# EUROPEAN PATENT SPECIFICATION

(11) **EP 2 099 267 B1**
(45) Date of publication and mention of the grant of the patent: **04.07.2012**
(21) Application number: 07832803.6
(22) Date of filing: 29.11.2007
(51) Int. Cl.: H05K 3/00

(54) **METHOD FOR MANUFACTURING METALLIZED CERAMIC SUBSTRATE CHIP**
VERFAHREN ZUR HERSTELLUNG EINES METALLISIERTEN KERAMIKSUBSTRATCHIPS
PROCÉDÉ DE FABRICATION DE PUCE DE SUBSTRAT EN CÉRAMIQUE MÉTALLISÉE

(30) Priority: 30.11.2006 JP 2006323007
(43) Date of publication of application: 09.09.2009
(73) Proprietor: Tokuyama Corporation, Shunan-shi, Yamaguchi-ken 745-8648 (JP)
(72) Inventor: YAMAMOTO, Yasuyuki, Shunan-shi Yamaguchi 745-8648 (JP); YAMAMOTO, Kouichi, Shunan-shi Yamaguchi 745-8648 (JP); MAEDA, Masakatsu, Shunan-shi Yamaguchi 745-8648 (JP)
(74) Representative: Smart, Peter John
(86) International application number: PCT/JP2007/073103
(87) International publication number: WO 2008/066133

(56) References cited:
- JP-A- 02 036 094
- JP-A- 2002 232 118
- JP-A- 2002 232 118
- JP-A- 2005 101 164
- JP-A- 2005 101 164
- JP-A- 2005 159 184
- US-A1- 2003 167 629
- US-A1- 2006 223 228

## Description

### Technical Field

The present invention relates to a method for manufacturing a metallized ceramic substrate chip useful as a substrate for mounting thereon laser diodes (LDs) and/or light-emitting diodes (LEDs).

### Background Art

As a substrate for mounting thereon LDs and/or LEDs, a metallized ceramic substrate composed of a ceramic substrate on which a metal wiring pattern is formed is used in view of requirement for insulation property, exoergic property, and the like. The substrate for mounting LDs and/or LEDs, in general, is extremely small in size (for example, the size of a sub-mount for mounting conventional LDs is about 1 mm x 1 mm x 0.3 mm by volume.). Therefore, when manufacturing the substrate, in view of its productivity, it is general to employ a method (hereinafter, refer to the method as "multi-piece method".) including the steps of: forming a wiring pattern in which a number of aligned "wiring pattern for individual substrates for mounting elements" (hereinafter, refer to as "wiring pattern unit".) on the surface of a large multi-piece ceramic substrate; and then, cutting the multi-piece ceramic substrate along the boundary of the wiring pattern unit (See Patent Documents 1 to 3.). When employing the multi-piece method, by regularly arranging the wiring pattern unit in a form of lattice and cutting the substrate along the respective linear borderlines drawn on the surface of the substrate lengthwise and crosswise, it is possible to manufacture a large number of substrate chips.

Moreover, in the multi-piece method, a multi-piece substrate in which dimensional precision of the wiring pattern unit itself and the alignment thereof is favorable and in which joining strength of the wiring pattern is high is developed. Thus, high-performance substrate chip can be efficiently manufactured (See Patent Document 2.).

As the method for cutting the ceramic substrate, dicing (die cutting) method for cutting by using rotary diamond blades and breaking method by making grooves in the surface of the substrate by laser are generally used. When these methods are employed, in order to avoid troublesome handling of discrete chips by cutting, the multi-piece substrate is adhered to an adhesive sheet in advance, and then, it is cut into pieces (See Patent Document 3.).

About the dicing method, there are problems related to the high cost as it requires change of blades with the wear thereof and related to determination of cut allowance in consideration of width of blades that discourages efficient use of the substrate. Further, when laser is used, there are problems of not only the determination of cut allowance but also alteration of the substrate by laser-irradiation.

As a cutting method without having the above problems, there is a known method (scribing method) having the steps of forming scribed grooves in the surface of the substrate and cutting (breaking) the substrate by stressing the substrate to create cracks from the above grooves (See Patent Documents 4 and 5.). About the scribing method, in order to form a scribed groove, a scriber having a cutter blade made of hard material like diamond is used. The scriber is known to have two types; these are roughly classified into a type using a fixed cutter blade (See Patent Document 6.) and a type using a rotary cutter blade (See Patent Document 7.).
Patent Document 1: Japanese Patent Application Laid-Open (JP-A) No. 8-239286
Patent Document 2: WO 2006/051881
Patent Document 3: JP-A No. 2006-024778
Patent Document 4: JP-A No. 2000-025030
Patent Document 5: Japanese Patent No. 3779237
Patent Document 6: JP-A No. 2005-289703
Patent Document 7: JP-A No. 2002-121040

Document US 2006223228 discloses the method for breaking a ceramic substrate along the grooves formed at the bottom surface and corresponding to the identification marks from the top surface. A depth of the grooves is set to be greater or equal to 1/5 of a thickness of the ceramic substrate in which a plurality of circuit units are embedded.

Document JP 2005101164 describes a method for manufacturing a circuit board wherein an insulated substrate may be divided with good yield into divided pieces, each comprising an electronic circuitry. The grooves are formed in relation to the formed circuits by dicing, grinding or laser beam. The process for removing the entire part or a part of the conductor from the groove prior to the process of dividing the circuit board into divided pieces is conducted.

### Disclosure of the Invention

### Problems to be solved by the Invention

The scribing method has been known from a long time ago as a cutting method of glass material. The method has been discovered that it is also useful for cutting a single-crystal material having cleavability; so, it is adopted as a method for cutting single-crystal substrate when manufacturing LED element itself. As disclosed in the above Patent Documents 4 and 5, the scribing method is found to be applicable to cutting sintered ceramic; however, there are few examples that the method was applied to cutting a metallized ceramic substrate. Thus, it is hard to say that the art has been established.

When the metallized ceramic substrate is cut using the scribing method, in order to surely cause cracks from the scribed groove, it is normal to form a scribed groove at a "ceramic portion on the surface of which a metal layer is not formed". For example, in the method shown in Patent Document 5, for cutting an AlN substrate on the surface of which gold is deposited, a scribed groove is formed in a reverse face where gold is not deposited. Meanwhile, Patent Document 4 employs a method including the steps of forming a scribed groove in a sintered ceramic substrate before forming a metal layer and then carrying out screen printing thereon of a paste for forming a metallized layer to form a metal wiring pattern.

The present inventors had seriously studied about application of scribing method for cutting the metallized ceramic substrate. As a result, they found the following problems. Firstly, when the sintered ceramic substrate is provided with a scribed groove for breaking, cracks are not necessarily caused in the vertical direction; so, it becomes apparent that the actual cutting line in the reverse face of the substrate deviates from the planned cutting line. This is because different from a case of cutting a material having cleavability such as single crystal, if a ceramic substrate made of sintered body of ceramic powder is cut, since cracks develop along the grain boundary, probability that cracks develop towards the unexpected direction is thought to become high when thickness of the substrate is thicker to the depth of the scribed groove. When the actual cutting line deviates from the planned cutting line in the substrate on which wiring pattern is formed, it is necessary to take wider cut allowance to raise yield of the product, which results in the decrease of its productivity.

Secondly, when a method like the one disclosed in Patent Document 4 is employed, the paste has to be fired after forming of scribed groove. Thus, it is discovered that problems such as the following (i) to (iii) is caused.

(i) Apart from the step for firing the substrate, a firing step which requires high temperature becomes necessary so that this not only causes complexity of the process but also raise the production cost;
(ii) depending on the temperature for firing the metal paste, the scribed groove disappears, which prevent cutting of the substrate;
(iii) even if the substrate can be cut along the scribed groove, a metal layer is formed over the scribed groove, so defects of the metal layer such as "partial peeling", "chip", or "burr" are caused when cutting thereby the yield is lowered.

Accordingly, an object of the present invention is to solve the above-described problems and to provide a method for efficiently manufacture the substrate chips in high yield which is capable of making effective use of the base material and of inhibiting defects at metallized portions when manufacturing metallized ceramic substrate chips by cutting (dividing) a ceramic substrate on the surface of which wiring patterns made of metal film is formed.

### Means for Solving the Problems

The present inventors had seriously studied the above problems. As a result, the inventors discovered that thickness of the metal layer was 5 µm or less even when the planned cutting line for forming the scribed groove passes through the metal layer but also the ceramic substrate can be neatly cut without causing defects in the metal layer when groove forming was carried out by using a scriber having a rotary cutter blade; then, the following invention was completed.

In other words, the first aspect of the present invention is a method for manufacturing a metallized ceramic substrate chip having a metal wiring pattern unit on at least one main surface by cutting (breaking), along boundary of the metal wiring pattern unit as a planned cutting line, a raw substrate comprising a metallized ceramic substrate on which a plurality of metal wiring pattern units are aligned on at least one main surface of a ceramic substrate, the method including the steps of:
(A) providing a metallized ceramic substrate as the raw substrate on one main surface, to be the cutting-initiating surface, of which a plurality of metal wiring pattern units formed by a metal layer at least a part of which thickness is 0.1 µm to 5 µm are aligned;
(B) setting a planned cutting line passing through at least a part of the metal layer having a thickness of 0.1 µm to 5 µm on the cutting-initiating surface of the raw substrate and forming along the planned cutting line a groove for creating at least a crack in the cutting-initiating surface side of the ceramic substrate by using a cutting wheel having a cutter blade being formed into substantially V shape in cross section along the circumferential portion of the disk rotating wheel; and
(C) cutting the raw substrate along the groove by giving load from the opposite face to the cutting-initiating surface of the raw substrate where the groove is formed therein.

In the step (B), "forming along the planned cutting line a groove for creating at least a crack in the cutting-initiating surface side of the ceramic substrate" means a way to form a groove by giving load to the ceramic substrate for creating at least a crack in the surface of the ceramic substrate disposed underneath the planned cutting line. If at least a crack is caused, it is possible to cut the raw substrate in the post-processes. The groove is normally formed such that the depth of the groove does not exceed thickness of the metal layer; however, the level of the groove's bottom is sometimes the same level as or deeper than the surface level of the ceramic substrate. It should be noted that even if the bottom of the groove reaches the same level as or deeper level than the surface level of the ceramic substrate, normally, metal of the metal layer remains in the bottom portion of the groove.

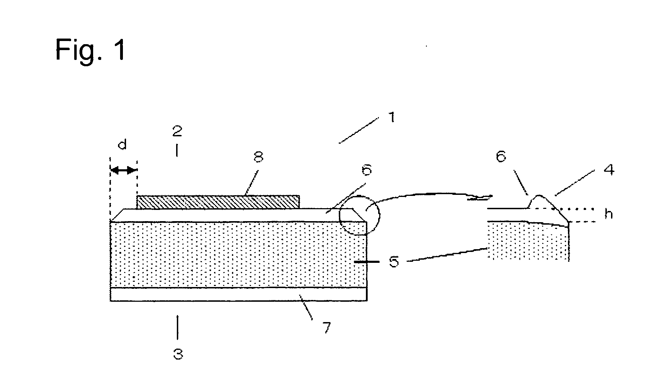

In the step (B), the groove to be formed along the planned cutting line is not specifically restricted as long as it can create at least a crack, as above, in the surface of the ceramic substrate; for example, the depth of the groove may be from 0.1 µm to 5 µm. The "depth of the groove" means a height from the deepest portion of the groove to the original metal surface (see "h" shown in Fig. 1.).

In the method of the first aspect of the invention, because employment of the method of the present invention is extremely advantageous, in the step (B) , a front face of the metal layer, whose thickness at the part where the planned cutting line passes through is within the range of 0.1 µm to 5 µm, is preferably formed with gold. Since gold is soft, when a type of scriber having a fixed cutter blade is used, the gold is scraped and cutting scrap is produced. Hence, if the scrap adheres to the wiring pattern, electrical reliability may be declined.

Moreover, in the first aspect of the invention, in order to make the handling of the manufactured metallized ceramic substrate chips easier, it is preferable to adhere the substrate to the adhesive sheet before cutting completely. So as to carry this out, preferably, (1) the method further includes the step (A+) for adhering the raw substrate to an adhesive sheet such that the opposite face to the cutting-initiating surface of the substrate becomes the bonding face, wherein the step (A+) is carried out before the step (B). Alternatively, preferably, (2) the method further includes the step (B+) for adhering the raw substrate where the groove is formed in the step (B) to an adhesive sheet such that the opposite face to the cutting-initiating surface of the substrate becomes the bonding face, wherein the step (B+) is carried out before the step (C).

In view of workability in the step (B) and easy handling of the groove-formed raw substrate, the mode (1) is preferably employed. In case where the step (B) is carried out without adhering the substrate to the adhesive sheet, when forming of grooves in the lengthwise (crosswise) direction is completed and the substrate is turned 90 degree to form grooves in crosswise (lengthwise) direction continuously, or in the period from the completion of the groove working to the beginning of the step (C), if a vertical load is given to the main surface of the raw substrate, the substrate may be broken along the groove for some reasons. On the other hand, the mode (1) can not only inhibit occurrence of the cracks but also make its handleability easier as the substrate itself is not broken into pieces even if cracks are created. Further, the mode (1) enables to obtain an effect in the step (B) for protecting the opposite face to the cutting-initiating surface of the raw substrate from flaw or fouling.

In addition, in view of feasibility of surely producing a source of crack in the surface of the ceramic substrate as the base of metal layer, the mode (2) is preferably adopted. In the mode (2) , different from the mode (1) , because the adhesive sheet does not function as a cushion when forming the scribed groove, necessary load for forming the grooves having a predetermined depth may be less than that in the mode (1), but also it is possible to surely form grooves having a regular depth.

The second aspect of the present invention is a metallized ceramic substrate including a plurality of metal wiring pattern units on the surface of a ceramic substrate, a groove for creating at least a crack in the surface of the ceramic substrate being formed along the boundary of the metal wiring pattern units on the surface where the metal wiring pattern units exist and at least a part of side face of the groove being formed by a metal. If there is at least a crack in the ceramic substrate, the metallized ceramic substrate can be cut to produce the chips. Moreover, in the surface of the ceramic substrate, grooves larger than crack may be formed.

In the second aspect of the invention, the formed groove is not specifically restricted as long as it can create cracks in the surface of the ceramic substrate; for instance, the depth may be from 0.1 µm to 5 µm.

The third aspect of the present invention is a metallized ceramic substrate-adhered sheet comprising an adhesive sheet and a metallized ceramic substrate of the second aspect of the invention, wherein the metallized ceramic substrate of the second aspect of the invention is adhered on the adhesive sheet such that the face opposite to the side of substrate where the groove is formed becomes the bonding face. The metallized ceramic substrates of the second and third aspects of the invention as well as the metallized ceramic substrate-adhered sheet are useful as in-process materials for the method of the first aspect of the invention.

The fourth aspect of the present invention is a metallized ceramic substrate chip having a metal wiring pattern unit on at least one main surface thereof, at least a part of periphery of the face having the metal wiring pattern unit being chamfered by forming a slope extending obliquely downward such that the lower end of the slope is 0.1 µm to 5 µm below from the surface of the chip and at least a part of the surface of the chamfered slope being formed by a metal. The metallized ceramic substrate chip can be obtained by the first aspect of the invention and it has the above structural characteristics derived from the manufacturing method. In addition to this, the metallized ceramic substrate chip itself shows excellent characteristics such as having a high dimensional precision at the face where the metal wiring pattern units are provided and hardly producing defects like burrs in the metal layer.

The fifth aspect of the present invention is a metallized ceramic substrate chip-adhered sheet comprising an adhesive sheet and a plurality of the metallized ceramic substrate chip according to the fourth aspect of the invention, wherein the plurality of the metallized ceramic substrate chips is aligned and adhered on the adhesive sheet such that the opposite face to the face where the metal wiring pattern unit is formed becomes the bonding face. The metallized ceramic substrate chip-adhered sheet makes the handling easier when the metallized ceramic substrate chip according to the fourth aspect of the invention is distributed and used.

The sixth and seventh aspects of the invention are methods for manufacturing the above metallized ceramic substrate chip-adhered sheet, both of the methods comprise the steps of: (I) providing a metallized ceramic substrate-adhered sheet in which the metallized ceramic substrate having a plurality of metal wiring pattern units on one surface is adhered onto the adhesive sheet such that the other main surface of the metallized ceramic substrate becomes the bonding face; and (II) cutting the metallized ceramic substrate which is adhered on the adhesive sheet.

In the sixth aspect of the invention, the step (I) further comprises the steps of: (A) providing a metallized ceramic substrate as a raw substrate on one main surface, to be a cutting-initiating surface, of which a plurality of metal wiring pattern units formed by a metal layer a part of which has a thickness of 0.1 µm to 5 µm are aligned; and (A+) adhering the raw substrate to an adhesive sheet such that the opposite face to the cutting-initiating surface becomes the bonding face,
the step (II) also further comprises the steps of: (B) setting a planned cutting line passing through at least a part of the metal layer having a thickness of 0.1 µm to 5 µm on the cutting-initiating surface of the raw substrate and forming along the planned cutting line a groove for creating at least a crack in the cutting-initiating surface side of the ceramic substrate by using a cutting wheel having a cutter blade being formed into substantially V shape in cross section along the circumferential portion of the disk rotating wheel; and (C) cutting the raw substrate, in which the groove is formed, along the groove by giving load from the opposite face to the cutting-initiating surface.

While, in the seventh aspect of the invention, the step (I) further comprises the steps of: (A) providing a metallized ceramic substrate as a raw substrate on one main surface, to be a cutting-initiating surface, of which a plurality of metal wiring pattern units formed by a metal layer a part of which has a thickness of 0.1 µm to 5 µm are aligned; and (B) setting a planned cutting line passing through at least a part of the metal layer having a thickness of 0.1 µm to 5 µm on the cutting-initiating surface of the raw substrate and forming along the planned cutting line a groove for creating at least a crack in the cutting-initiating surface side of the ceramic substrate by using a cutting wheel having a cutter blade being formed into substantially V shape in cross section along the circumferential portion of the disk rotating wheel; and (B+) adhering the raw substrate, in which the groove is formed in the step (B), to an adhesive sheet such that the opposite face to the cutting-initiating surface of the raw substrate becomes the bonding face,
the step (II) also further comprises the step of: (C) cutting the raw substrate, in which the groove is formed, along the groove by giving load from the opposite face to the cutting-initiating surface.

Further, in the sixth and seventh aspects of the invention, the grooves to be formed in the step (B) is not particularly limited as long as it does creates at least a crack in the surface of the ceramic substrate; for example, the depth may be 0.1 µm to 5 µm.

### Effects of the Invention

According to the first aspect of the invention, when manufacturing the metallized ceramic substrate chip using multi-piece method, as the cut allowance at a time of cutting can be narrowed as much as possible, it is possible to effectively use the base material. The invention also inhibits occurrence of defects in the metallized portion and efficiently manufactures the substrate chip in higher yield.

In addition, the metallized ceramic substrate chip of the fourth aspect of the invention obtained by the method itself exhibits excellent characteristics such as having a high dimensional precision at the face where the metal wiring pattern units are provided and hardly producing defects like burrs in the metal layer.

Further, by employing the methods according to the sixth and seventh aspect of the invention, the metallized ceramic substrate chip may be developed into a form of the metallized ceramic substrate chip-adhered sheet. By having such a form, handling at a time of distribution and use becomes easier.

### Brief Description of the Drawings

Fig. 1 is a cross-sectional view of the metallized ceramic substrate chip of the present invention obtained in Example 1 and an enlarged view of a part of the cross-sectional view.

### Description of the Reference Numerals

- 1: metallized ceramic substrate chip
- 2: front face (cutting-initiating surface)
- 3: reverse face
- 4: chamfered slope
- h: height of the chamfered slope
- 5: sintered aluminum nitride substrate
- 6: front face metal layer
- 7: reverse face metal layer
- 8: solder layer
- d: distance from the solder layer end portion (end face) to the cutting line

### Best Mode for Carrying Out the Invention

Similar to the conventional multi-piece method, the method of the present invention is to manufacture a metallized ceramic substrate chip having a metal wiring pattern unit on at least a main surface of the substrate chip by cutting (breaking) a raw substrate including a metallized ceramic substrate, on at least a main surface of which a plurality of metal wiring pattern units are aligned, along the boundary of the metal wiring pattern unit as a planned cutting line.

In the method of the present invention, in order to narrow the cut allowance at a time of cutting as much as possible, to inhibit occurrence of defects in the metallized portion, and to manufacture the substrate chip in higher yield, the following steps (A), (B), and (C) must be included as essential processes.

(A) The step for providing a metallized ceramic substrate as the raw substrate in which a plurality of metal wiring pattern units, which are formed by a metal layer at least a part of whose thickness is 0.1 µm to 5 µm, are aligned on at least a main surface to be the cutting-initiating surface; (B) the step for determining a planned cutting line passing through at least a part of the top surface of the metal layer whose thickness is 0.1 µm to 5 µm on the cutting-initiating surface of the raw substrate, and forming a groove along the planned cutting line by using a cutting wheel having a cutter blade forming substantially V shape in cross section along the circumferential portion of the disk rotating wheel so as to create cracks in at least a cutting-initiating surface of the ceramic substrate; and (C) the step for giving load to the opposite face of the raw substrate to the cutting-initiating surface where the groove is formed and for cutting the raw substrate along the groove.

As for the step (A), a raw substrate comprising a metallized ceramic substrate, in which a plurality of the metal wiring pattern units formed by a metal layer at least a part of whose thickness is 0.1 µm to 5 µm are aligned on one main surface as a cutting-initiating surface of the ceramic substrate, is provided.

As the ceramic substrate composing main part of the raw substrate, a sintered ceramic made of a substance selected from a group consisting of: aluminum nitride, beryllium oxide, silicon carbide, alumina, mullite, boron nitride, silicon nitride, and zirconia is suitably used. Among them, aluminum nitride is particularly suitably used because it has a high thermal conductivity which allows efficient diffuse of heat generated from the LD elements and/or LED elements and its coefficient of thermal expansion is closer to that of Si as a typical material of these elements. In this respect, since reliability of the elements becomes higher, it is preferable that the substrate has a higher thermal conductivity; therefore, a substrate whose thermal conductivity is 170 W/mK or more, further 200 W/mK or more is suitably used. Thickness of the substrate is not specifically restricted; thickness of the substrate to be used as a general sub-mount or package is normally about 0.1 to 2 mm.

In addition, particle diameter of the ceramics composing the substrate is not specifically limited to; when the particle diameter is set within the relatively small range between e.g. 0.5 µm and 2.0 µm, section of the raw substrate becomes flat and smooth, which is advantageous. Moreover, by contraries, when the particle diameter is set within the relatively larger range between e.g. 7 µm and 13 µm, thermal conductivity of the ceramic substrate is raised, which is also an advantageous effect.

On one main surface as the cutting-initiating surface of the ceramic substrate, a plurality of metal wiring pattern units are aligned. Here, the metal wiring pattern unit means a metal wiring pattern which exists on the surface of a finally-manufactured metallized ceramic substrate chip but also a wiring pattern to become a port and/or a tie bar, formed as required, for electrically bonding the neighboring metal wiring patterns. If the port and tie bar are provided, it becomes possible to plate over all of the wiring pattern units at once. The metal wiring pattern which exists in the surface of the finally-manufactured metallized ceramic substrate chip is normally includes at least one selected from a group consisting of: a metal layer to be a base for soldering elements (a thin-film pattern including a solder metal may be formed over the metal layer.); an electrode layer to be an electrode for supplying electric power to the element; and an inner wiring for electrically-connecting between the element mounting face and the opposite face of the substrate. The simplest example of the inner wiring is what is called via hole where a through hole is filled with a conductive material; other than this, more complex mode can be available depending on the application. Further, in the case where entire surface of one main surface to be the cutting-initiating surface is covered by the metal layer, when inner wiring such as via hole is developed into a certain pattern and a plurality of the patterns are aligned, even if one metal wiring pattern unit on the surface only could be seen apparently, in the present invention, it shall be deemed that a plurality of the metal wiring pattern units are aligned. Meanwhile, the solder pattern itself may become the metal wiring pattern unit.

In the method of the invention, the raw substrate is cut along the boundary of the metal wiring pattern unit as the cutting line. The line as the cutting line (planned cutting line) passes through the surface of the metal wiring pattern unit. The area where the planned cutting line of the metal wiring pattern unit passes through must be formed by a metal layer having a thickness within the range between 0.1 µm and 5 µm. In the case where thickness of a part of the metal layer where the planned cutting line passes through is over 5 µm, when a groove (scribed groove) is formed in the step (B), source of cracks cannot be effectively made in the ceramic substrate underneath the metal layer. Thereby, cutting along the planned cutting line becomes difficult. In order to surely and neatly cut the raw substrate along the planned cutting line, the part where the planned cutting line of the metal wiring pattern unit passes through is preferably formed by a metal layer having a thickness of 0.2 µm to 3 µm. Moreover, when the raw substrate has an inner wiring, in the same point of view as above, it is preferable not to have the inner wiring having a thickness of over 5 µm just beneath the planned cutting line.

As seen from the above-described reasons, at least a part of the metal wiring pattern existing in one main surface as the cutting-initiating surface of the ceramic substrate must be formed by a metal layer having a thickness of 0.1 µm to 5 µm, more preferably 0.2 µm to 3 µm. It should be noted that all the metal wiring pattern units existing in the surface of the finally-manufactured metallized ceramic substrate chip do not necessarily have such a thickness. When the planned cutting line only passes through the part to be the above described port and tie bar, only the part must have thickness of the above range. Further, when the planned cutting line passes through the metal wiring pattern unit existing in the surface of the finally-manufactured metallized ceramic substrate chip, as long as thickness of the passing portion is within the above range, there is no problem at all even if thickness of the rest portion exceeds 5 µm.

The method for aligning the above metal wiring pattern units in the surface of the ceramic substrate is not particularly limited to. Examples of the methods to be employed include: thick-film processing by making pattern printing using a metal paste and firing thereafter; a method for sputtering or depositing a metal on the ceramic substrate through a mask; a method including the steps of sputtering or depositing a metal on the surface of the ceramic substrate and etching the unnecessary portion; further, a method in combination with these methods and plating method. Thickness of the metal layer at the portion where the planned cutting line passes through can be adjusted by controlling thickness of the metal paste to be coated, time for depositing metal, or plating time within a predetermined range. Also, the metal layer may be firstly coated to be over 5 µm in thickness and then thickness of the particular portion may be reduced by using methods like etching and polishing.

In the step (A) for providing the raw substrate, the face opposite to the cutting-initiating surface is not specifically restricted; no metal layer may be formed thereon, the entire surface may be covered by a single metal layer, or same metal wiring pattern units as or different metal wiring pattern units from that on the cutting-initiating surface may be plurally aligned. In general, about the substrate for mounting LDs and/or LEDs, complex patterns are often formed over the element mounting face so that high dimensional precision is required about the element mounting face. On the other hand, in the opposite face (reverse face), in most of the case, no electrode is formed for the purpose of insulation or a metal layer is formed over the entire surface for soldering; thus, high dimensional precision is not required as much as the element mounting face. Consequently, when cutting (breaking) the substrate in the step (C), no problem is caused even when crack does not develop vertically but does deviate from the planned cutting line.

In the step (B), on the cutting-initiating surface of the raw substrate provided in the step (A), a planned cutting line passing through at least a part of the metal layer having a thickness of 0.1 µm to 5 µm is provided. Next, by using "a cutting wheel having a cutter blade being formed into substantially V shape in cross section along the circumferential portion of the disk rotating wheel", a groove having a depth of 0.1 µm to 5 µm is formed along the planned cutting line. If the planned cutting line does not pass through the metal layer but does only pass through the surface of the ceramic substrate, it is known that the ceramic substrate can be cut by conventional scribing method without causing any problem; however, it is out of scope of the present invention. Moreover, even if the planned cutting line passes through the metal layer, when thickness of the cutting portion is over 5 µm, clear-cutoff cannot be made. Therefore, it is desirable that the planned cutting line does not pass through the metal layer whose thickness is over 5 µm, particularly preferably the metal layer whose thickness is over 3 µm.

Further, in the step (B), when the groove (scribed groove) is formed on the planned cutting line, it is necessary to use a scriber having a rotary cutter blade, as it were, a scriber including "a cutting wheel having a cutter blade being formed into substantially V shape in cross section along the circumferential portion of the disk rotating wheel". When a scriber having a fixed cutter blade is used, the metal layer produces cutting scrap so that the scrap adheres to the wiring pattern which sometimes deteriorates the electrical reliability. In a case where a scriber having a rotary cutter blade is used, groove is formed only by the substantial pressing force of the cutter blade without scratching the metal layer; thus the above problem is not caused. The above-described problem in emerging cutting scrap is significant when using a raw substrate in which the surface of the uppermost layer of the metal layer is particularly made of soft gold. The method of the invention is particularly useful in a circumstance using such a raw substrate.

As a cutter blade of the cutting wheel having a cutter blade being formed into substantially V shape in cross section along the circumferential portion of the disk rotating wheel, one made of diamond or cemented carbide can be suitably used. Shape of wheel may be a shape of Japanese abacus bead (the cross-sectional side view thereof is substantially rhomboid.) and the V-shape in cross section of the cutter blade desirably has an open angle in a range between 100 degree and 130 degree. If the open angle becomes smaller, the width of the scribed groove also becomes narrower; whereas, product life of the cutter blade is shortened. Diameter of the wheel is desirably 1 mm or more and 5 mm or less; when the diameter becomes larger, contact area to the substrate increases, so that micro-crack as a source of crack becomes difficult to be created. The scriber using such a cutting wheel is disclosed in, for example, Patent Document 7.

In the step (B), by rolling the cutting wheel with load on the planned cutting line on the substrate, the groove (scribed groove) is formed. The load at the blade edge when forming a groove is preferably 0.049 N or more and 4.9 N or less, particularly preferably 0.98 N or more and 2.45 N or less. In addition, movement speed (scribing speed) is preferably 10 mm/s or more and 200 mm/s or less, particularly preferably 100 mm/s or more and 150 mm/s or less. When cutting a thicker substrate, larger load is preferably given. In order to inhibit occurrence of chipping (microscopic chip at the corner portion of the ceramics), decreasing the load and raising the number of scribing are desirable. In view of locational precision and certainty of cutting, depth of the scribed groove is 0.1 µm or more and 5 µm or less, preferably 0.2 µm or more and 3 µm or less. When depth of the scribed groove is over 5 µm, a large number of minute cracks or source of cracks occur in the ceramic substrate at the bottom portion of the scribed groove; thereby, spread of cracks into various directions at a time of cutting tends to lower the locational precision of cutting (deviation from the planned cutting line becomes larger.) or chipping tends to occur.

In the cutting wheel, cutter blade is formed into substantially V-shape in cross section along circumferential portion of the disk rotating wheel, line (ridge line) which connects apexes of the V-shape is not necessarily circle. For example, a wheel in the above Patent Document 7 has a shape of 16-gonal to 300-gonal. So, the scribed groove formed in the step (B) is the one where dotted concave portions continue. In the present invention, such a mode can even be regarded as a groove. So as to carry out favorable cutting, it is preferable that dotted concave portions are densely-connected in the formed groove. Therefore, when the scribed groove is formed, it is preferable to make the cutting wheel repeatedly pass along the planned cutting line. Twice to five times passage enables to make a groove having a continuous line. It should be noted that since the scribed groove as described above is formed by a continuous dotted concaves, the depth seen from a microscopic view is different depending on the dots' location. So, in the present invention, the depth of groove is defined as an average depth (from the surface of the substrate in which the groove is formed) throughout the line of the deepest portion (center portion when the groove is V-shape) in the cross-sectional view of the groove. Depth of the groove can be determined by e.g. a simple method observing the groove by using metallographic microscope based on the difference in height between the lens level when taking the focus on the bottom portion of the groove and the lens level when taking the focus on the surface of the substrate. In addition, as a measurement method for determining more accurate depth, a method, in which distribution of depth of the groove of every location is measured using apparatus such as laser microscope, microscopic laser displacement meter, atomic force microscope, and electronic microscope and then calculate the average depth based on the measurement result, can be adopted. The depth of the scribed groove can be controlled by adjusting load at the blade edge, scribing speed, and number of passage on the planned cutting line. When the groove passes through both the ceramic portion and the metal layer portion, depth in the ceramic portion and depth in the metal layer portion are often different; nevertheless, in this respect, as long as depth of individual portions of the groove meets the above-described range, it is favorable. Further, when the groove is formed in the surface of metal layer, shape of the cutter blade is transferred to the metal layer so that cross-sectional shape of the groove becomes substantially V shape and source of cracks is formed in the ceramic layer underneath. The shape of groove formed in the ceramic portion is not necessarily V shape; the groove formed in the ceramic portion exposed on the surface can be detected as a concave portion where the vicinity of center portion is the deepest. From the viewpoint of possibility of favorable cutting, depth of the scribed groove formed in the metal layer is preferably 10% or more and 100% or less, particularly 20% or more and 80% or less of the thickness of the base metal layer.

In the raw substrate, when metal wiring patterns are respectively linearly arranged in a matrix form at regular intervals, scribed groove may be created in a form of lattice or grid. If such a groove is to be formed, either a substrate or a cutter head rotatably attached to the cutting wheel is made slidable; then, the cutting wheel is abutted on the substrate and moved into the rotating direction (Y-axis direction) of the cutting wheel to form a scribed groove. Later, once releasing the abutment of the cutting wheel, the substrate or the cutter head is slid at predetermined intervals and other scribed grooves are formed in the same manner as above. Further, when formation of all of the scribed grooves in the Y-axis direction is completed, the substrate or the cutter head is turned 90 degrees and other scribed grooves may be formed in the direction perpendicular to Y-axis (X-axis) in the same manner as above.

In the step (C), load is added to the substrate, in which grooves have been formed by the step (B), from the opposite face to the cutting-initiating surface and the raw substrate is cut into pieces along the grooves. By giving load from the opposite face to the cutting-initiating surface of the substrate, cracks which are created by the formation of grooves can be spread in the substantially vertical direction that enables to carry out cutting the opposite face along the substantially planned cutting line. In order to cut more accurately (less deviated from the planned cutting line), it is preferable to attach the cutter blade just behind the scribed groove and to cut the substrate by giving load to the cutter blade.

The cutting method can be suitably carried out by using "a cutting apparatus, disclosed for example in Patent Document 5, comprising: a substrate supporting portion for supporting a substrate; a base portion; a blade fitting portion for fitting a blade for cutting the substrate on the bottom of the apparatus and being movable in the vertical direction to the base portion; a driving portion for moving the base portion into the vertical direction and making the blade approach to or separate from the substrate; a weight portion being arranged at the upper side of the blade fitting portion, being slidable along a guide provided on the base portion in the vertical direction, and making the blade fitting portion move towards the substrate side by moving downward; a weight stopping portion capable of stopping the weight portion at a position of desirable height; a projecting portion which is protrudedly provided to the base portion and stopping the downward movement of the blade fitting portion by placing the blade fitting portion thereon". The apparatus employs a special method using the weight portion as a method for loading the substrate through a blade. Other than this, for instance, it is possible to use another apparatus employing a method for making a blade, which is set at a position over the substrate, move downward at a constant rate to abut the blade to the substrate and then raising the blade again after giving a predetermined load to the substrate for a certain period.

In order to abut the blade just behind the scribed groove, firstly, a slit having a shape corresponding to the blade is provided at the portion underneath the blade of the substrate supporting portion, thereafter, the substrate is placed on the substrate supporting portion such that the surface in which the scribed groove is formed (cutting-initiating surface) faces downward, together with this, the slit portion is observed by camera and so on while transferring the substrate into the horizontal direction to detect the passage of the groove, and finally, movement of the substrate may be stopped when position of the groove meets that of the slit. When the substrates are made slide one after another and the same operation is repeated, following to this, cutting of the substrate in the X-axis direction (or Y-axis direction) is carried out and the cut substrate is turned 90 degree to cut the substrate in the Y-axis direction (or X-axis direction), a metallized ceramic substrate chip can be manufactured.

At these operations, as the substrate is thrust into the slit portion, flaws are sometimes caused on the metallized surface. So, a method for inhibiting the cause of flaws may be taken by adhering a protective sheet to the metallized surface. The protective sheet include a commercially available PET (polyethylene terephthalate) film, and thickness is preferably 20 µm or more and 70 µm or less.

As the load given to the face opposite to the face (cutting-initiating surface) where scribed groove of the substrate is formed through the blade is changed depending on kinds of the ceramics, depth of the scribed groove, and thickness of the substrate; it is preferably determined in advance after a certain test. The adoptable load is normally in the range of 0.98 N or more and 49 N or less.

In the method of the invention, for the purpose of preventing the metallized ceramic substrate chip from broken into pieces at a time of cutting and of improving cutting operationability, either of the following two method may be carried out: i.e. (1) a method further comprising the step of seat adhesion (A+) for adhering the raw substrate to an adhesive sheet such that the opposite face to the cutting-initiating surface of the substrate becomes the bonding face, wherein the step (A+) is carried out before the step (B); or (2) a method further comprising the step (B+) for adhering the raw substrate in which the groove is formed in the step (B) to an adhesive sheet such that the opposite face to the cutting-initiating surface of the substrate becomes the bonding face, wherein the step (B+) may be carried out before the step (C).

In view of operationability of the step (B) and easy handling of the raw substrate after the formation of groove, the method (1) is preferably employed. In a case where the step (B) is carried out without adhering the raw substrate to the adhesive sheet, when lengthwise (or crosswise) grooves forming are completed and crosswise (or lengthwise) groove are to be formed after 90 degree turning of the substrate, or a period from the completion of groove forming to the beginning of the step (C), if load is given for some reasons to the perpendicular direction to the main surface of the raw substrate, the substrate is sometimes broken along the groove. In contrast, in the method (1), cause of break-up can be inhibited and even if break-up is caused, the broken substrate does not be into pieces, thus handling becomes easy. Further, about the method (1), in the step (B) , it is capable of obtaining a protective effect for protecting the opposite face to the cutting-initiating surface of the raw substrate from flaw or fouling.

Still further, in view of surely causing the source of crack in the ceramic layer underneath the metal layer, the method (2) is preferably employed. In the method (2), different from the method (1), the adhesive sheet does not function as a cushion when forming the scribed groove so that necessary load for forming the grooves having a predetermined depth becomes less compared with that of the method (1) , but also it is capable of surely forming grooves having a certain depth.

As an adhesive sheet, the adhesive sheet used for conventional sheet for adhering chips can be used without any limitation. As adhesive force can be adequately adjusted, it is preferable to use an adhesive sheet having, on the front face, an adhesive material layer including a carboxylic acid ester type adhesive material which is cured by irradiating ultraviolet. This kind of sheet is commercially available and industrially available. Such a sheet, in general, has a structure where a carboxylic acid ester type adhesive material layer which is cured by irradiating ultraviolet is coated within the range between 5 µm and 50 µm in thickness on a single layered or multilayered base sheet made of at least one synthetic resin such as PVC (polyvinyl chloride), PET (polyethylene terephthalate), PO (polyolefin), or EVA (ethylene vinyl alcohol) having a thickness of 10 µm or more and 200 µm or less.

By applying the above method (1) or (2), it is possible to manufacture a metallized ceramic substrate chip-adhered (fixed) sheet where a plurality of the metallized ceramic substrate chip are aligned and adhered on the adhesive sheet. As the metallized ceramic substrate chips are adhered to the adhesive sheet to form a metallized ceramic substrate chip-adhered (fixed) sheet, handling of the chips at a time of distribution and use becomes easier. In the manufacturing of the metallized ceramic substrate chip-adhered (fixed) sheet, chips are preferably treated not to drop off in the distribution system after completion of cutting of the raw substrate and the adhesive force of the adhesive layer may preferably be adjusted such that the chips are adhered to the sheet with an adequate adhesive force where the individual chips when used are easily peeled from the sheet (chips are easily picked up) by means of ultraviolet irradiation and so on (See Japanese Patent Application Laid-Open No. 2003-249464.).

When employing a method for cutting a part of the metal wiring pattern existing on the surface of the finally-manufactured metallized ceramic substrate chip, cross section of the scribed groove formed in the metal layer in the step (B) is V shape; about cutting in the step (C), since cracks spread from the bottom portion of the groove, a part of at least outer circumference of the cutting-initiating surface of the metallized ceramic substrate chip to be manufactured forms a slope extends obliquely downward (is chamfered) such that the lower end of the slope is lower in the range of 0.1 µm or more and 5 µm or less from the surface of the chips (height of the chamfered slope: h, see Fig. 1.). Further, a part of the surface of the chamfered slope is formed by metal and the metallized ceramic substrate chip whose the metal layer hardly has any defects such as burrs, peeling can be obtained. When a scribed groove is formed in the metal layer, the metal layer tends to be deformed by the load through the cutter blade of the disk rotating wheel and level of the metal layer tends to be raised in some degree at the edge of the groove.

Still further, the method of the invention enables to cut the substrate particularly in the cutting-initiating surface at high degree of dimensional precision and positional accuracy. If the planned cutting line is a straight line as a premise, misaligned distance from the planned cutting line to the actual cutting line may be set within 20 µm or less, more preferably 10 µm or less. In other words, the above metallized ceramic substrate chip includes one whose shape of the main surface is substantially rectangle sheet body and in which the line of the side constituting the rectangle in the cutting-initiating surface is ± 20 µm or less in width (distance) of misalignment from the planned cutting line (straight line) (it should be noted that plus (+) means either side (right and left) of misalignment from the planned cutting line; minus (-) means the misalignment of the opposite side thereto.), more preferably ± 10 µm or less.

The metallized ceramic substrate chip for mounting LD element and/or LED element is generally used such that these elements are mounted (connected) thereon and then the obtained the ceramic substrate is mounted on a larger size of wiring substrate. Recently, demand for downsizing of the final products is high, so that mounting to the above-described wiring substrate also requires a high degree of positional accuracy. Since the metallized ceramic substrate chip of the present invention has a high degree of dimensional precision as described above, it can sufficiently respond to the requirement.

### Examples

Hereinafter, the invention will be more specifically described by way of the following examples; however, the present invention is not limited by these examples.

### Example 1

Step (A): A sintered aluminum nitride substrate was prepared with a shape of 2-inch-square (a square of 5.08 cm x 5.08 cm) and a thickness of 0.5 mm; metal layers were formed over the entire surface of both sides of the substrate by sputtering method. The metal layer (film) was a three-layer structure and it consisted, from the base side, of: 0.1 µm thick Ti layer as the first layer, 0.2 µm thick Pt layer as the second layer, and 1. 0 µm thick Au layer as the third layer (uppermost layer). Then, after coating a resist on the surface of one face (as the front face) to be the cutting-initiating surface of the substrate, a resist pattern was formed by development and exposure using mask in which holes of 0.6 mm square (a square of 0.6 mm x 0.6 mm) were arranged in a matrix at 1.1 mm intervals (that is, each distance between centers of neighboring holes from right to left as well as up and down was 1.1 mm). Thereafter, AuSn (Au: 80 mass %) solder metal was deposited over the entire surface of the face on which a resist pattern had been formed to form a solder layer of 5 µm in thickness; following to this, by peeling the resist layer (a solder layer was formed thereon. ) , a raw substrate in which 0.6 mm square solder patterns were arranged in a matrix at 1.1 mm intervals.

Step (B): A straight line (a straight line, wherein distance from one end of the solder pattern to the straight line was 20 µm) passing through the metal layer (Ti: 0.1 µm /Pt: 0.2 µm /Au: 1.0 µm) which was located between neighboring solder patterns of the above raw substrate was determined as the planned cutting line; V-shaped cross-sectional scribed grooves having a depth of 1 µm was formed on the planned cutting line by using a "scriber having a cutting wheel including a diamond cutter blade being formed into V shape in cross section along the circumferential portion of the disk rotating wheel". Conditions for forming the groove were: load at the blade edge: 0.98 N, scribing speed: 100 mm/s, and number of passage of the cutting wheel: twice. Also, so as to make the all the solder patterns become independent, the scribed grooves were created in a form of lattice or grid in both longitudinal direction and crosswise direction. Depth of the scribed groove was measured by using a laser microscope. The depth of the groove means a height from the undermost of the groove to the original metal surface (See "h" in Fig. 1.).

Step (C): The raw substrate in which the scribed groove was formed in the previous step was set in a breaking apparatus such that the reverse face thereof faced upward and then the substrate was cut by giving load through a blade being set just behind the scribed groove. It should be noted that the above breaking apparatus adopts a means including the steps of: moving downward the blade disposed at the upper side of the substrate held by the substrate supporting portion at a constant rate to abut the blade to the substrate; giving a predetermined load to the substrate for a certain time period; and thereafter, raising the blade again. In the breaking apparatus, a slit having a shape corresponding to the blade was provided at the portion underneath the blade of the substrate supporting portion, the slit portion was observed by camera and so on while transferring the substrate into the horizontal direction to detect the passage of the groove, and finally, movement of the substrate was stopped when position of the groove met that of the slit. Cutting, as described above, was carried out to all the scribed grooves in turn and a 1.1 mm square substrate chip was formed. Cutting was completed in the all the planned cutting lines without causing any problems and planned number of substrate chip was manufactured. The cross sectional view of the obtained substrate chip is shown in Fig. 1.

As shown in Fig. 1, in the obtained substrate chip 1, respective metal layers (a combination of Ti: 0.1 µm /Pt: 0.2 µm /Au: 1.0 µm) 6, 7 were formed over the entire surface of the front face 2 and the reverse face 3 of the sintered aluminum nitride substrate 5; a metal wiring pattern consisting of one solder layer 8 was formed over the metal layer 6 of the front face 2.

From the manufactured chip as above, 50 samples were picked up at random and observed using a microscope, cut cross section was almost vertical and peripheral portion of the chip' s front face 2 was chamfered towards the reverse face side. Chamfered slope 4 reflected the shape of the scribed groove, the height "h" (corresponding to depth of the scribed groove) thereof from the front face to the lower side (towards reverse face side) was 1 µm and the surface was formed by the metal having the above three-layer structure. A mound was observed in the metal layer at the peripheral portion of the front face of the substrate chip, the height from the chip surface was 2 µm maximum. The mound of the metal layer is caused when the scribed grooves were formed, the metal layer at the portion is adhered with the substrate in an integrated manner; it is different from burrs, namely, thin and saw-toothed substantially scale-shape metal scrap which is produced at the edge of the cut metal pieces by cutting metal. In addition, no defect (burrs, peeling, chips) was seen in the metal layer about all of 50 chips. Further, about all of 50 chips, distance "d" from the end portion (end face) of the solder layer was 13 µm minimum and 24 µm maximum.

### Example 2

After providing the raw substrate in the step (A) of Example 1, as the step (A+), the obtained raw substrate was adhered to an adhesive sheet having a thickness of 90 µm and larger size than that of the substrate such that the reverse face of the raw substrate was to be the joining surface so as to make a raw substrate-adhered sheet. Later, except for using the obtained raw substrate-adhered sheet, forming of scribed grooves was carried out in the same manner as the step (B) of Example 1. Conditions for forming grooves were the same as those of Example 1; however, when depth of the formed grooves was measured, the grooves of Example 2 were 0.7 µm in depth, which was slightly shallower than that of Example 1. When forming of the scribed groove was completed, except for using the raw substrate-adhered sheet in which scribed grooves were formed, cutting was carried out in the same manner as the step (C) of Example 1 so as to manufacture the substrate chip. Cutting was completed about all the planned cutting lines without having any problems and a planned number of substrate chips could be manufactured. Moreover, when cutting, particularly, when cutting in the longitudinal direction was completed and then the substrate was turned 90 degree to cut in the crosswise direction, the cutting was smoothly carried out in good operating condition without breaking the cut substrate into pieces.

When the obtained 50 chips were evaluated in the same manner as Example 1, height of the chamfered slope (corresponding to depth of the groove) was 0.7 µm, mound of the metal layer in the peripheral portion of the chips' front face was at a maximum of 1.5 µm, no defect was seen in the surface metal layer about all the chips and distance of misalignment from the planned cutting line of the cutting line was within the range of ± 7 µm.

### Example 3

The steps (A) and (B) were carried out in the same manner as Example 1 and then scribed grooves were formed in the front face of the raw substrate. Thereafter, as the step (B+), the obtained raw substrate was adhered to an adhesive sheet having a thickness of 90 µm and larger size than that of the substrate such that the reverse face of the raw substrate was to be the joining surface so as to make a raw substrate-adhered sheet. Later, except for using the obtained raw substrate-adhered sheet, cutting was carried out in the same manner as the step (C) of Example 1 and a substrate chip was manufactured. Cutting was completed about all the planned cuttings line without having any problems and a planned number of substrate chips could be manufactured. Moreover, when cutting, particularly, when cutting in the longitudinal direction was completed and then the substrate was turned 90 degree to cut in the crosswise direction, the cutting was smoothly carried out in good operating condition without breaking the cut substrate into pieces.

When the obtained 50 chips were evaluated in the same manner as Example 1, the results were similar to those of Example 1.

### Comparative example 1 (An example of cutting by dicing)

A raw substrate was manufactured in the same manner as the step (A) of Example 1 and similar planned cutting lines to the one made in the step (B) of Example 1 was determined about the obtained raw substrate. Then, by dicing on the planned cutting line by using a 0.1 mm thick diamond blade, 1 mm square chips were manufactured. Cutting was completed about all the planned cuttings line without having any problems and a planned number of substrate chips could be manufactured. However, when the substrate chips were picked up and observed at random from the manufactured 50 substrate chips, burrs were observed in peripheral portion of the front face of all the substrate chips and the height thereof was at a maximum of 14 µm. Moreover, distance from the cross section to the solder layer end portion was 0.00 mm minimum and 0. 039 mm maximum. In the area of the cross section, chipping was observed; some of the portion thereof even had chips extended down to the bottom of the solder layer.

### Comparative example 2 (An example of Laser cutting)

A raw substrate was manufactured in the same manner as the step (A) of Example 1 and similar planned cutting lines to the one made in the step (B) of Example 1 was determined about the obtained raw substrate. Then, by irradiating laser on the planned cutting lines, grooves having a depth of 0.1 mm were formed. With the groove as the starting point, cutting was carried out in the same manner as the step (C) of Example 1 and 1.1 mm square chips were manufactured. Cutting was completed about all the planned cuttings line without having any problems and a planned number of substrate chips could be manufactured. Nevertheless, when the obtained substrate chip was observed, molten Au was scattered at the periphery of the substrate chip, which became the dirt; further, flying substances were adhered on the solder layer.

### Comparative example 3 (An example using a scriber of stationary cutter blade)

A raw substrate was manufactured in the same manner as the step (A) of Example 1 and similar planned cutting lines to the one made in the step (B) of Example 1 was determined about the obtained raw substrate. Later, scribed grooves were formed by using a pen-shape glass cutter (scriber) where a diamond cutter blade was fixed. Although the conditions for forming the grooves were the same as those of Example 1, metal layer of the front face was scraped at a time of groove forming, which results in the occurrence of metal scrap.

### Comparative example 4 (An example where a scribed groove was formed on the reverse face)

A raw substrate was manufactured in the same manner as the step (A) of Example 1. Later, scribed grooves were formed in the reverse face of the obtained raw substrate in the same manner as the step (B) of Example 1. In this respect, it was defined that this planned cutting line was just behind the planned cutting line of Example 1. Then, except for setting the substrate in the breaking apparatus such that the front face (the face where the solder layer was formed) of the raw substrate faces downward, cutting was carried out in the same manner as the step (C) of Example 1 to manufacture 1.1 mm square substrate chips. Cutting was completed about all the planned cuttings line without having any problems and a planned number of substrate chips could be manufactured. However, when 50 samples were picked up at random from the manufactured substrate chip and observed, although no burr was observed at the peripheral portion of the front face of the substrate, the distance of misalignment of the actual cutting line from the planned cutting lines of front face was at a maximum of 50 µm. Some of the cutting lines a part of which overlap the solder layer were also observed.

### Comparative example 5 (An example where scribed groove was made too deep)

In Example 1, except for setting the load given at the blade edge in the step (B) to be 9.8 N and forming the scribed groove whose depth is 7 µm, substrate chips were manufactured in the same manner as Example 1. Cutting was completed about all the planned cutting lines without having any problems and a planned number of substrate chips could be manufactured. However, when 50 samples were picked up at random from the manufactured substrate chip and observed in the same manner as Example 1, although no burr was observed at the peripheral portion of the front face of the substrate, chipping caused by defects of ceramic particles were seen and the distance of local misalignment at the portion from the planned cutting line was 30 µm maximum. Moreover, height of the mound of metal layer at the peripheral portion of front face of the substrate chip was 2 µm.

### Comparative example 6 (An example where thickness of the metal layer exceeded 5 µm.)

A sintered aluminum nitride substrate having a size of 2-inch square with 0.5 mm in thickness was provided and Cu paste containing glass component was coated over the entire surface of one side of the substrate by screening method. Thereafter, the paste was dried and then baked at the temperature of 800 °C; a copper (Cu) film having a thickness of 20 µm was formed. Later, plating of Ni and Au were provided by turn over the copper (Cu) film to form a 1 µm-thick Ni layer and a 0.3 µm thick Au layer. Following to this, a resist was applied over the obtained metal layer; then, in the same manner as the step (A) of Example 1, 0.6 mm square AuSn (Au: 80 mass %) solder patterns (thickness: 5 µm) were formed in a matrix at 1.1 mm intervals to manufacture a raw substrate.

By using the raw substrate thus obtained, scribed grooves were formed in the same manner as the step (B) of Example 1 and the substrate was cut in the same manner as the step (C) of Example 1. Nevertheless, a part of the planned cutting line could not be sufficiently cut; thereby only 10% of the initially planned number of substrate chips could be obtained.

The above has described the present invention associated with the most practical and preferred embodiments. thereof.

### Industrial Applicability

The metallized ceramic substrate chip manufactured by the method of the present invention can be used as a substrate for mounting laser diodes (LDs) and/or light-emitting diodes (LEDs).

## Claims

1. A method for manufacturing a metallized ceramic substrate chip having a metal wiring pattern unit on at least one main surface by cutting, along the boundary of the metal wiring pattern unit as a planned cutting line, a raw substrate comprising a metallized ceramic substrate on which a plurality of metal wiring pattern units are aligned on at least one main surface of a ceramic substrate, the method comprising the steps of:
(A) providing a metallized ceramic substrate as the raw substrate on one main surface of which, which is the cutting-initiating surface, are aligned a plurality of metal wiring pattern units formed by a metal layer at least a part of which has a thickness of 0.1 µm to 5 µm;
(B) setting a planned cutting line passing through at least one part of the metal layer having a thickness of 0.1 µm to 5 µm on the cutting-initiating surface of the raw substrate and forming along the planned cutting line a groove with a depth of 0.1 µm to 5 µm and of 10% to 100% of the thickness of said part of the metal layer for creating at least one crack in the cutting-initiating surface side of the ceramic substrate by using a cutting wheel having a cutter blade along the circumferential portion of the wheel which blade has a substantially V shaped cross section; and
(C) cutting the raw substrate along the groove by applying force to the raw substrate from the face opposite to the cutting-initiating surface of the raw substrate in which the groove is formed.

2. The method according to claim 1, wherein in the step (B) a front face of the metal layer, whose thickness at the part where the planned cutting line passes through is within the range of 0.1 µm to 5 µm, is formed with gold.

3. The method according to claim 1 or claim 2, further comprising the step (A+) of adhering the raw substrate to an adhesive sheet such that the face opposite to the cutting-initiating surface of the substrate is adhered to the adhesive sheet, wherein the step (A+) is carried out before the step (B).

4. The method according to claim 1 or claim 2, further comprising the step (B+) of adhering the raw substrate where the groove is formed in the step (B) to an adhesive sheet such that the face opposite to the cutting-initiating surface of the substrate is adhered to the adhesive sheet, wherein the step (B+) is carried out before the step (C).

5. A method for manufacturing a metallized ceramic substrate chip-adhered sheet, the method comprising the steps of:
(I) providing a metallized ceramic substrate-adhered sheet in which the metallized ceramic substrate having a plurality of metal wiring pattern units on one surface is adhered onto the adhesive sheet such that the other main surface of the metallized ceramic substrate is adhered to the adhesive sheet; and
(II) cutting the metallized ceramic substrate which is adhered on the adhesive sheet,
the step (I) comprising the steps of:
(A) providing a metallized ceramic substrate as a raw substrate on one main surface of which, which is a cutting-initiating surface, are aligned a plurality of metal wiring pattern units formed by a metal layer a part of which has a thickness of 0.1 µm to 5 µm; and
(A+) adhering the raw substrate to an adhesive sheet such that the opposite face to the cutting-initiating surface is adhered to the adhesive sheet,
the step (II) comprising the steps of:
(B) setting a planned cutting line passing through at least one part of the metal layer having a thickness of 0.1 µm to 5 µm on the cutting-initiating surface of the raw substrate and forming along the planned cutting line a groove with a depth of 0.1 µm to 5 µm and of 10% to 100% of the thickness of said part of the metal layer for creating at least one crack in the cutting-initiating surface side of the ceramic substrate by using a cutting wheel having a cutter blade along the circumferential portion of the wheel which blade has a substantially V shaped cross section; and
(C) cutting the raw substrate, in which the groove is formed, along the groove by applying a force to the raw subtrate from the face opposite to the cutting-initiating surface,
wherein said method produces a metallized ceramic substrate chip-adhered sheet comprising a plurality of metallized ceramic substrate chips such that at least a part of the periphery of a main surface of the chip on which a metal wiring pattern unit exists is chamfered by forming a sloped extending obliquely downward such that the lower end of the slope is 0.1 µm to 5 µm below from said main surface of the chip, and such that at least a part of the surface of the chamfered slope is formed of a metal.

## Patentansprüche

1. Ein Verfahren zur Herstellung eines metallisierten Keramiksubstratchips, der eine metallene Verdrahtungsmustereinheit auf mindestens einer Hauptoberfläche durch Schneiden einer geplanten Schnittlinie entlang der Begrenzung der metallenen Verdrahtungsmustereinheit und ein Rohsubstrat aufweist, welches ein metallisiertes Keramiksubstrat umfasst, auf dem eine Vielzahl von metallenen Verdrahtungsmustereinheiten auf mindestens einer Hauptoberfläche eines Keramiksubstrats angeordnet sind, mit folgenden Verfahrensschritten umfasst:
(A) Bereitstellen eines metallisierten Keramiksubstrats als Rohsubstrat, wobei auf einer Hauptoberfläche, welche die schnittauslösende Oberfläche ist, eine Vielzahl von metallenen Verdrahtungsmustereinheiten angeordnet sind, welche durch eine Metallschicht, die mindestens teilweise eine Dicke von 0,1 µm bis 5 µm aufweist, ausgebildet sind;
(B) Setzen einer geplanten Schnittlinie, welche durch mindestens einen Teil der Metallschicht mit einer Dicke von 0,1 µm bis 5 µm auf der schnittauslösenden Oberfläche des Rohsubstrats verläuft, und Ausbilden einer entlang der geplanten Schnittlinie verlaufenden Kerbe mit einer Tiefe von 0,1 µm bis 5 µm und 10 % bis 100 % der Dicke des besagten Teils der Metallschicht, um mindestens einen Riss auf der Seite der schnittauslösenden Oberfläche des Keramiksubstrats durch Verwendung eines Schneidrads zu erzeugen, welches eine Schneidklinge mit einem im wesentlichen V-förmigen Querschnitt entlang des umlaufenden Teils des Schneidrades aufweist, und
(C) Schneiden des Rohsubstrats entlang der Kerbe durch Aufwenden von Kraft auf das Rohsubstrat von der Seite welche der schnittauslösenden Oberfläche des Rohsubstrats gegenüberliegt in welchem die Kerbe ausgebildet ist.

2. Das Verfahren nach Anspruch 1, wobei in Schritt (B) eine Vorderfläche der Metallschicht, deren Dicke in dem Teil, in welchem die geplante Schnittlinie verläuft, einen Wert von 0,1 µm bis 5 µm aufweist, aus Gold gebildet ist.

3. Das Verfahren nach Anspruch 1 oder Anspruch 2, welches zusätzlich den Schritt (A+) aufweist, in welchem das Rohsubstrat auf eine Klebefolie geklebt wird, sodass die Seite, welche der schnittauslösenden Oberfläche des Substrats gegenüberliegt, auf die Klebefolie geklebt wird, wobei der Schritt (A+) vor dem Schritt (B) ausgeführt wird.

4. Das Verfahren nach Anspruch 1 oder Anspruch 2, welches weiter den Schritt (B+) aufweist, in welchem das Rohsubstrat, in welchem die Kerbe in Schritt (B) ausgebildet wird, auf eine Klebefolie geklebt wird, sodass die Seite, welche der schnittauslösenden Oberfläche des Substrats gegenüberliegt, auf die Klebefolie geklebt wird, wobei der Schritt (B+) vor dem Schritt (C) ausgeführt wird.

5. Ein Verfahren zum Herstellen einer Klebefolie mit aufgeklebten metallisierten Keramiksubstratchips, wobei das Verfahren die folgenden Schritte umfasst:
(I) Bereitstellen einer Klebefolie mit aufgeklebtem metallisiertem Keramiksubstrat, wobei das metallisierte Keramiksubstrat, welches eine Vielzahl von metallenen Verdrahtungsmustereinheiten auf einer Oberfläche aufweist, auf die Klebefolie geklebt wird, sodass die andere Hauptoberfläche des metallisierten Keramiksubstrats auf die Klebefolie geklebt wird; und
(II) Schneiden des metallisierten Keramiksubstrats, welches auf die Klebefolie geklebt ist,
wobei Schritt (I) die folgenden Schritte umfasst:
(A) Bereitstellen eines metallisierten Keramiksubstrats als ein Rohsubstrat, wobei auf einer Hauptoberfläche, welche eine schnittauslösende Oberfläche ist, eine Vielzahl von metallenen Verdrahtungsmustereinheiten angeordnet sind, die durch eine Metallschicht ausgebildet sind, wobei mindestens ein Teil der Metallschicht eine Dicke von 0,1 µm bis 5 µm aufweist; und
(A+) Kleben des Rohsubstrats auf eine Klebefolie, sodass die der schnittauslösenden Oberfläche gegenüberliegende Seite auf die Klebefolie geklebt wird,
und Schritt (II) die folgenden Schritte umfasst:
(B) Setzen einer geplanten Schnittlinie, welche durch mindestens einen Teil der Metallschicht mit einer Dicke von 0,1 µm bis 5 µm auf der schnittauslösenden Oberfläche des Rohsubstrats verläuft, und Ausbilden einer entlang der geplanten Schnittlinie verlaufenden Kerbe mit einer Tiefe von 0,1 µm bis 5 µm und 10 % bis 100 % der Dicke des besagten Teils der Metallschicht, um mindestens einen Riss auf der Seite der schnittauslösenden Oberfläche des Keramiksubstrats durch Verwendung eines Schneidrads zu erzeugen, welches eine Schneidklinge mit einem im wesentlichen V-förmigen Querschnitt entlang des umlaufenden Teils des Schneidrades aufweist, und
(C) Schneiden des Rohsubstrats, in welchem die Kerbe ausgebildet ist, entlang der Kerbe durch Aufwenden von Kraft auf das Rohsubstrat, von der Seite, welche der schnittauslösenden Oberfläche gegenüberliegt,
wobei das besagte Verfahren eine Klebefolie mit aufgeklebten metallisierten Keramiksubstratbausteinen erzeugt, welche eine Vielzahl von metallisierten Keramiksubstratbausteinen aufweist, wobei mindestens ein Teil des Randbereiches einer Hauptoberfläche des Bausteins, auf welchem sich die metallene Verdrahtungsmustereinheit befindet, abgeschrägt ist, durch Ausbilden einer Schräge, welche so abgeschrägt ist, dass das untere Ende der Schräge 0,1 µm bis 5 µm unterhalb der besagten Hauptoberfläche des Bausteins liegt, und mindestens ein Teil der Oberfläche der Schräge aus einem Metall gebildet ist.

## Revendications

1. Procédé de fabrication d'une puce de substrat en céramique métallisée ayant une unité à motifs de câblage métallique sur au moins une surface principale consistant à découper, le long de la délimitation de l'unité à motifs de câblage métallique selon une ligne de découpe prévue, un substrat brut comprenant un substrat en céramique métallisée sur lequel une pluralité d'unités à motifs de câblage métallique sont alignées sur au moins une surface principale d'un substrat en céramique, le procédé comprenant les étapes consistant à :
(A) fournir un substrat en céramique métallisée sous la forme d'un substrat brut sur une surface principale duquel, qui est la surface d'amorçage de découpe, sont alignées une pluralité d'unités à motifs de câblage métallique formées par une couche métallique dont au moins une partie a une épaisseur de 0,1 µm à 5 µm ;
(B) définir une ligne de découpe prévue traversant au moins une partie de la couche métallique ayant une épaisseur de 0,1 µm à 5 µm sur la surface d'amorçage de découpe du substrat brut et former le long de la ligne de découpe prévue une rainure d'une profondeur de 0,1 µm à 5 µm et de 10 % à 100 % de l'épaisseur de ladite partie de la couche métallique pour créer au moins une fente dans le côté de la surface d'amorçage de découpe du substrat en céramique en utilisant une roulette de coupe ayant une lame de découpe le long de la partie circonférentielle de la roulette, la lame ayant une section transversale sensiblement en V ; et
(C) découper le substrat brut le long de la rainure en appliquant une force sur le substrat brut de la face opposée vers la surface d'amorçage de découpe du substrat brut dans laquelle est formée la rainure.

2. Procédé selon la revendication 1, dans lequel dans l'étape (B) une face avant de la couche métallique, dont l'épaisseur au niveau de la partie traversée par la ligne de découpe prévue est dans la plage de 0,1 µm à 5 µm, est formée avec de l'or.

3. Procédé selon la revendication 1 ou la revendication 2, comprenant en outre l'étape (A+) consistant à coller le substrat brut sur une feuille adhésive de telle sorte que la face opposée à la surface d'amorçage de découpe du substrat soit collée à la feuille adhésive, l'étape (A+) étant réalisée avant l'étape (B).

4. Procédé selon la revendication 1 ou la revendication 2, comprenant en outre l'étape (B+) de collage du substrat brut où la rainure est formée dans l'étape (B) sur une feuille adhésive de telle sorte que la face opposée à la surface d'amorçage de découpe du substrat soit collée à la feuille adhésive, l'étape (B+) étant réalisée avant l'étape (C).

5. Procédé de fabrication d'une feuille collée à une puce de substrat en céramique métallisée, le procédé comprenant les étapes consistant à :
(I) fournir une feuille collée à un substrat en céramique métallisée, dans laquelle le substrat en céramique métallisée ayant une pluralité d'unités à motifs de câblage métallique sur une surface est collé sur la feuille adhésive de telle sorte que l'autre surface principale du substrat en céramique métallisée est collée sur la feuille adhésive ; et
(II) découper le substrat en céramique métallisée qui est collé sur la feuille adhésive,
l'étape (I) comprenant les étapes consistant à :
(A) fournir un substrat en céramique métallisée sous la forme d'un substrat brut sur une surface principale duquel, qui est une surface d'amorçage de découpe, sont alignées une pluralité d'unités à motifs de câblage formées par une couche métallique dont une partie a une épaisseur de 0,1 µm à 5 µm ; et
(A+) coller le substrat brut sur une feuille adhésive de telle sorte que la face opposée à la surface d'amorçage de découpe est collée à la feuille adhésive,
l'étape (II) comprenant les étapes consistant à :
(B) définir une ligne de découpe prévue traversant au moins une partie de la couche métallique ayant une épaisseur de 0,1 µm à 5 µm sur la surface d'amorçage de découpe du substrat brut et former le long de la ligne de découpe prévue une rainure d'une profondeur de 0,1 µm à 5 µm et de 10 % à 100 % de l'épaisseur de ladite partie de la couche métallique pour créer au moins une fente dans le côté de la surface d'amorçage de découpe du substrat en céramique en utilisant une roulette de coupe ayant une lame de découpe le long de la partie circonférentielle de la roulette, la lame ayant une section transversale sensiblement en V ; et
(C) découper le substrat brut, dans lequel est formée la rainure, le long de la rainure en appliquant une force sur le substrat brut de la face opposée vers la surface d'amorçage de découpe,
ledit procédé produisant une feuille collée à une puce de substrat en céramique métallisée comprenant une pluralité de puces de substrat en céramique métallisée de telle sorte qu'au moins une partie de la périphérie d'une surface principale de la puce sur laquelle se trouve une unité à motifs de câblage métallique est chanfreinée en formant une pente s'étendant obliquement vers le bas de telle sorte que l'extrémité inférieure de la pente est de 0, µm à 5 µm en dessous de ladite surface principale de la puce, et de telle sorte qu'au moins une partie de la surface de la pente chanfreinée est formée d'un métal.
